Europäisches Patentamt

European Patent Office

Office européen des brevets

Numéro de publication: **0 286 823**
A1

## DEMANDE DE BREVET EUROPEEN

(21) Numéro de dépôt: 88103495.3

(22) Date de dépôt: 07.03.88

(51) Int. Cl.⁴ **H01L 39/12**

(30) Priorité: 17.03.87 FR 8703717

(43) Date de publication de la demande:
**19.10.88 Bulletin 88/42**

(84) Etats contractants désignés:
**AT BE CH DE ES FR GB GR IT LI LU NL SE**

(71) Demandeur: **COMPAGNIE GENERALE D'ELECTRICITE Société anonyme dite:**
**54, rue La Boétie**
**F-75382 Paris Cédex 08(FR)**

(72) Inventeur: **Deslandes, Francis**
**Route de Danzé Saint Ouen**
**F-41100 Vendome(FR)**
Inventeur: **Michel, Claude**
**1 allée des Epis**
**F-14200 Herouville St Clair(FR)**
Inventeur: **Provost, Jackie**
**1 rue des Hauts Marquets**
**Villons les Buissons F-14610 Thaon(FR)**
Inventeur: **Raveau, Bernard, Prof.**
**25 allée Guillaume le Conquérant**
**F-14112 Beuville(FR)**
Inventeur: **Tournier, Robert**
**27 route de Lyon**
**F-38000 Grenoble(FR)**

(74) Mandataire: **Weinmiller, Jürgen et al**
**Lennéstrasse 9 Postfach 24**
**D-8133 Feldafing(DE)**

(54) Oxyde de cuivre à valence mixte supraconducteur et son procédé de fabrication.

(57) La présente invention se rapporte à un oxyde de cuivre à valence mixte mixte supraconducteur, ayant une formule du type :

$Y_{1+\epsilon} Ba_{2-\epsilon} Cu_3 O_{8-y}$

$-0,2 \leq \epsilon \leq +0,2$

$0 < y < 1,5$

Cet oxyde est obtenu paar synthèse directe à partir d'oxydes ultrapurs $Y_2 O_3$, $Cu O$ et de carbonate de baryum.

## Oxyde de cuivre à valence mixte supraconducteur et son procédé de fabrication

L'invention se rapporte à un oxyde de cuivre à valence mixte et à son procédé de fabrication.

Avec des températures critiques de 30 à 46 K, les oxydes ternaires de cuivre à valence mixte $La_{2-x}A_xCuO_{4-y}(A = Ba, Sr)$ ouvrent une nouvelle voie de recherche dans le domaine de la supraconductivité. Les récents résultats observés dans le système La-Cu-O montrent que la présence d'ions alcalinoterreux n'est pas indispensable à l'existence de propriétés supraconductrices. En revanche, il apparait clairement que la valence mixte Cu(II)-Cu(III), ainsi que l'effet Jahn-Teller du cuivre divalent jouent un rôle important dans le phénomène de supraconductivité, en accord avec le modèle récemment élaboré par Labbé et Bok. L'yttrium en raison de ses propriétés voisines de celles du lanthane et de sa plus petite taille était susceptible de conduire à des matériaux originaux. La mise en évidence récemment dans le système Y-Ba-Cu-O d'une supraconductivité à 91 K est en accord avec ce point de vue.

Comme décrit par R.C. Chu, Ph. Hor, R.L. Meng, L. Gao, J.J. Huang, V.Q. Wang, M.K. Wu, J.R. Ashburn, C.J. Torng dans "Physical Review letters", 58, 1987, pages 908 et 911 a été mis en évidence un matériau de formulation $Y_{1,2} Ba_{0,8} Cu O_{4-y}$ possédant une transition résistive à 91 K, montrant qu'il y avait supraconductivité. Mais ils observent pour cette composition un mélange de phases. Ils n'ont pu isoler la phase responsable de la supraconductivité. Dans ces conditions, la supraconductivité est pour cette composition faible en volume. Les auteurs l'expliquent d'ailleurs par des phénomènes de percolation. Ainsi, si l'effet supraconducteur est observé, la nature de la phase qui est à l'origine de cet effet reste inconnue jusqu'à présent : les auteurs observent un mélange d'oxydes dont certains n'ont pu être identifiés.

La présente invention a pour but de synthétiser une phase supraconductrice à une température inférieure à 91 K dans toute sa masse pour améliorer sa supraconductivité.

L'invention propose à cet effet un oxyde de cuivre à valence mixte, caractérisé en ce qu'il a une formule du type :

$$Y_{1+\epsilon} Ba_{2-\epsilon} Cu_3 O_{8-y}$$
$$-0,2 \leq \epsilon \leq + 0,2$$
$$0 < y < 1,5$$

Un tel matériau présente les qualités suivantes :

- température critique très élevée : 91 K ;
- conducteur métallique à température ordinaire avec une résistivité de $4.10^{-3}$ Ω cm à 293 K ;
- transition franche brutale très étroite à 91 K ;
- résistance nulle en dessous de 91 K ;
- possibilité de courants critiques très élevés ;
- supraconductivité conservée jusqu'à une densité de courant de 10 A/cm².

L'invention propose en outre un procédé d'obtention d'un tel matériau obtenu par synthèse directe à partir des oxydes ultrapurs $Y_2O_3$, CuO, et du carbonate de baryum, les oxydes de départ étant intimement mélangés dans les proportions correspondant à la stoechiométrie de la formule recherchée, puis chauffés à l'air en creuset de platine pendant 6 à 12 heures, le mélange obtenu étant ensuite broyé, compacté sous forme de disques de 4mm d'épaisseur et de 10mm de diamètre, fritté sous courant d'oxygène pendant deux heures à 1050°C et finalement refroidi dans les mêmes conditions avec une vitesse de descente en température de 30°C par heure.

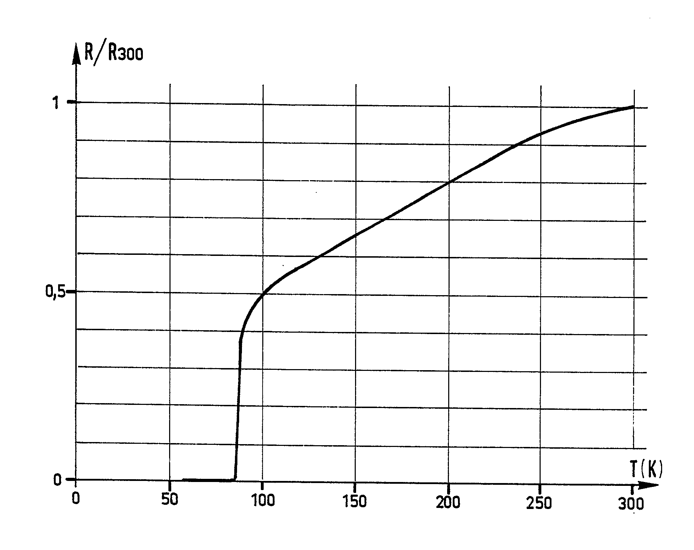

Les caractéristiques et avantages de l'invention ressortiront d'ailleurs de la description qui va suivre, à titre d'exemple non limitatif, en référence à la figure annexée qui représente une courbe illustrant les caractéristiques de l'oxyde de cuivre selon l'invention.

La présente invention décrit la synthèse et les propriétés supraconductrices d'une nouvelle pérovskite déficitaire en oxygène de formule $YBa_2Cu_3O_{8-y}$.

L'obtention de phases de formule générale $Y_{1-x}Ba_xCuO_{3-y}$ a été effectuée par synthèse directe à partir des oxydes ultrapurs $Y_2O_3$, CuO, et du carbonate de baryum. Les oxydes de départ sont intimement mélangés dans les proportions correspondant à la stoechiométrie de la formule recherchée puis chauffés à l'air en creuset de platine pendant 6 à 12 heures. Le mélange obtenu est ensuite broyé, compacté sous forme de disques de 4 mm d'épaisseur et de 10mm de diamètre, fritté sous courant d'oxygène pendant deux heures à 1050°C et finalement refroidi dans les mêmes conditions avec une vitesse de descente en température de 30°C par heure.

Dans ces conditions une pérovskite déficitaire en oxygène a été isolée pour la composition x = 0,66 correspondant à la formulation $YBa_2Cu_3O_{8-y}$. L'étude de cette phase par diffraction x et diffraction électronique montre qu'elle possède la symétrie quadratique avec pour paramètres, a = 3,85 Å~$a_p$ et c = 11,69 Å~3$a_p$. Les groupes d'espace possibles pour cette phase (absence de conditions d'extinction) sont compatibles avec un ordre par plans des ions baryum et yttrium. Les deux formules limites $YBa_2Cu_3O_7$ et $YBa_2Cu_3O_8$ sont toutes deux compatibles avec un ordre des lacunes oxygène par plans parallèles à (001) entraînant dans le premier cas un plan double de pyramides

$CuO_5$ alternant avec un plan de groupes carrés $CuO_4$, et dans le second modèle limite des plans doubles mixtes formés de pyramides $CuO_5$ et d'octaèdres $CuO_6$.

Un caractère métallique ($\rho \approx 4\ 10^{-3}$ Ω cm à 293 K) avec une transition supraconductrice très nette à 91 K sont observés pour cette composition, comme représenté sur la figure, qui montre sans ambiguité que cette pérovskite est la phase responsable de la supraconductivité dans le système Y-BA-Cu-O. Il est intéressant de noter que le rapport $c/3a > 1$ fait apparaître un effet Jahn-Teller marqué, et que la valence mixte du cuivre est également très nette dans cette phase. En revanche le caractère bidimensionnel de cet oxyde qui peut également être décrit comme constitué de couches doubles de polyèdres $CuO_5$ et $CuO_6$ assemblées par l'intermédiaire d'ions baryum est moins marqué que dans les oxydes $La_{2-x}A_xCuO_{4-y}$.

On observe des propriétés similaires pour un corps de formule

$Y_{1+\epsilon} Ba_{2-\epsilon} Cu_3 O_{8-y}$

$-0,2 \leq \epsilon \leq +0,2$

$0 < y < 1,5$

## Revendications

1. Oxyde de cuivre à valence mixte, caractérisé en ce qu'il a une formule du type :

$Y_{1+\epsilon} Ba_{2-\epsilon} Cu_3 O_{8-y}$

$-0,2 \leq \epsilon \leq +0,2$

$0 < y < 1,5$.

2. Procédé de fabrication de l'oxyde de cuivre selon la revendication 1, caractérisé en ce que l'obtention de phases de formule générale $Y_{1-x}Ba_xCuO_{3-y}$ a été effectuée par synthèse directe à partir des oxydes ultrapurs $Y_2O_3$, $CuO$, et du carbonate de baryum, les oxydes de départ étant intimement mélangés dans les proportions correspondant à la stoechiométrie de la formule recherchée puis chauffés à l'air en creuset de platine pendant 6 à 12 heures, le mélange obtenu étant ensuite broyé, compacté sous forme de disques de 4mm d'épaisseur et de 10mm de diamètre, fritté sous courant d'oxygène pendant deux heures à 1050°C et finalement refroidi dans les mêmes conditions avec une vitesse de descente en température de 30°C par heure.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | PHYSICAL REVIEW LETTERS, vol. 58, no. 9, 2 mars 1987, pages 908-910, New York, US; M.K. WU et al.: "Superconductivity at 93 K in a new mixed-phase Y-Ba-Cu-O compound system at ambient pressure" * En entier * --- | 1,2 | H 01 L 39/12 |
| D,A | PHYSICAL REVIEW LETTERS, vol. 58, no. 9, 2 mars 1987, pages 911-912, New York, US; P.H. HOR et al.: "High-pressure study of the new Y-Ba-Cu-O superconducting compound system" * En entier * --- | 1,2 | |
| P,X | ADVANCED CERAMIC MATERIALS- CERAMIC SUPERCONDUCTORS, vol. 2, no. 3B, juillet 1987, pages 364-371, American Ceramic Society Publication, Westerville, OH, US; D.W. JOHNSON et al.: "Fabrication of ceramic articles from high Tc superconducting oxides" * Pages 364-365: "Experimental" * --- | 1,2 | DOMAINES TECHNIQUES RECHERCHES (Int. Cl.4) H 01 L |
| P,X | PHYSICAL REVIEW LETTERS, vol. 58, no. 16, 20 avril 1987, pages 1676-1679, The American Physical Society, New York, US; R.J. CAVA et al.: "Bulk superconductivity at 91 K in single-phase oxygen-deficient perovskite Ba2YCu3O9-delta" * Résumé * ----- | 1 | |

Le présent rapport a été établi pour toutes les revendications

| Lieu de la recherche | Date d'achèvement de la recherche | Examinateur |
|---|---|---|
| LA HAYE | 10-06-1988 | BAILLET B.J.R. |